(19)

Europäisches
Patentamt
European
Patent Office
Office européen
des brevets

(11)  **EP 1 271 620 B1**

(12)  **EUROPEAN PATENT SPECIFICATION**

(45) Date of publication and mention
of the grant of the patent:
**29.05.2013  Bulletin 2013/22**

(51) Int Cl.:
***H01L 21/67*** *(2006.01)*  ***C30B 25/10*** *(2006.01)*

(21) Application number: **01420142.0**

(22) Date of filing: **21.06.2001**

(54) **Method and apparatus for heat treatment of semiconductor films**

Verfahren und Vorrichtung zur Wärmebehandlung von Halbleiterfilmen

Procédé et dispositif de traitement thermique de couches semiconductrices

(84) Designated Contracting States:
**DE FR GB IT**

(43) Date of publication of application:
**02.01.2003  Bulletin 2003/01**

(73) Proprietor: **Kim, Hyoung June**
**Dongan-gu,**
**Anyang-city,**
**Gyeonggi-do 431-755 (KR)**

(72) Inventor: **Kim, Hyoung June**
**Dongan-gu,**
**Anyang-city,**
**Gyeonggi-do 431-755 (KR)**

(74) Representative: **Stona, Daniel et al**
**Etude Daniel Stona**
**13B Chemin du Levant**
**BP 55**
**01210 Ferney Voltaire (FR)**

(56) References cited:
WO-A-01/27363   US-A- 3 424 628
US-A- 3 594 227   US-A- 3 608 519
US-A- 3 633 537   US-A- 3 783 822
US-A- 4 180 618   US-A- 4 263 336
US-A- 5 074 017   US-A- 6 151 447

**Description**

FIELD OF THE INVENTION

The present invention relates to methods and apparatuses for heat treatment of semiconductor films upon thermally susceptible non-conducting substrates at a minimum thermal budget are required, and more particularly, to a polycrystalline silicon thin-film transistors (poly-Si TFTs) and PN diodes on glass substrates for various applications of liquid crystal displays (LCDs), organic light emitting diodes (OLEDs), and solar cells.

BACKGROUND OF THE INVENTION

Liquid crystal displays (LCDs) and organic light emitting diodes (OLEDs) grow rapidly in the flat panel displays. In the present time, those display systems employ the active matrix circuit configuration using TFTs. Fabrication of thin film transistors (TFTs) on glass substrate is necessary in those applications.

TFT-LCDs typically uses the TFTs composing amorphous Si films as an active layer (i.e., a-Si TFT LCD). Recently, interests on the development of TFTs using polycrystalline silicon films instead of amorphous silicon films (i.e., poly-Si TFT LCD) is spurred because of their superior image resolution and merit of simultaneous integration of pixel area with peripheral drive circuits. In the area of OLEDs, uses of poly-Si TFTs provide evident advantages over a-Si, since the current derivability of poly-Si TFTs are substantially higher than that of a-Si TFTs, thus, leading to a higher operation performance.

The most formidable task for the fabrication of poly-Si devices on the commercially available glass substrates is a development of heat treatment method at a minimum thermal budget that the glass substrate withstands. Glass is easily deformed when exposed to the temperature above 500°C for substantial length of time. The important heat treatment steps that require high thermal budget for the fabrication of poly-Si devices include crystallization of amorphous Si films and electrical activation of implanted dopants for P(or N)-type junction. Those heat treatments typically require high thermal budgets, unavoidably causing damage or distortion of glass.

Various methods for solving those problems have been developed. Those methods will be briefly reviewed with distinguishing areas of crystallization of amorphous Si and dopant activation.

(1) Heat treatments for crystallization of amorphous Si into polycrystalline Si

A poly-Si film is typically obtained through deposition of an amorphous Si film by chemical vapor deposition method (CVD) and subsequent post-deposition crystallization heat treatments.

Solid phase crystallization (SPC) is a popular method for crystallizing amorphous silicon. In this process, the amorphous silicon is subject to heat treatments at temperatures approaching 600°C for a period of at least several hours. Typically, glass substrates are processed in a furnace having a resistive heater source. The SPC method can yield the device-quality polycrystalline silicon with typical electron mobilities of TFTs of 50~100 cm.sup.2/Vs. over 10 hours. However, high thermal budget of this method leads to damage and/or distortion of used glass substrates.

Various crystallization methods exist for converting amorphous Si into polycrystalline Si at low temperatures without damaging glass. Important methods for this are excimer laser crystallization (ELC) and metal-induced crystallization (MIC).

The ELC method utilizes the nano-second laser pulse to melt and solidify the amorphous silicon into a crystalline form. Theoretically, this offers the possibility of annealing the amorphous Si at its optimum temperature without degrading the glass substrate upon which it is mounted. However, this method has critical drawbacks for its use in mass production. The grain structure of poly-Si film through this process is extremely sensitive to the laser beam energy, so that an uniformity in grain structure and hence the device characteristics can not be achieved. Also, the beam size of the laser is relatively small. The small beam size requires multiple laser passes, or shots to complete the crystallization processes for large size glass. Since it is difficult to precisely control the laser, the multiple shots introduce non-uniformities into the crystallization process. Further, the surface of ELC poly-Si films is rough, which also degrades the device performance. The ELC also has a problem of hydrogen eruption when deposited amorphous Si has high hydrogen contents, which is usually the case in the plasma enhanced chemical vapor deposition (PECVD). In order to prevent the hydrogen eruption, the heat treatment for dehydrogenation should be required at high temperature (450-480°C) for long period (>2 hrs). In addition to the problems in the area of processes, the system of ELC process equipment is complicated, expensive, and hard to be maintained.

The MIC process involves addition of various metal elements such as Ni, Pd, Au, Ag, and Cu onto amorphous Si films in order to enhance the crystallization kinetics. Use of this method offers to the crystallization at low temperatures below 600°C. This method, however, is limited by poor crystalline quality of poly-Si and metal contamination. The metal contamination causes a detrimental leakage current in the operation of poly-Si TFTs. Another problem of this method is a formation of metal silicides during the process. The presence of metal silicides leads to an undesirable residue problem during the following etching process step.

(2) Heat treatments for dopant activations

In addition to crystallization process, another heat treatment process with high thermal budget is the dopant activation anneals. In order to form n type (or p type) regions such as source and drain regions of TFTs, dopants such as arsenic, phosphorus, or boron are implanted into Si films using ion implantation or plasma doping method. After doping of dopants, silicon is annealed for electrical activation (activation anneals). Similarly to a heat treatment of crystallization, annealing in the furnace with a resistance heater source is normally carried out. This process requires high temperatures near 600°C and long duration time. Therefore, a new method for reducing thermal budget is needed and presented in the prior art. The excimer laser anneals (ELA) and rapid thermal anneals (RTA) are presented for those purposes. The ELA uses the identical process mechanism with that of the ELC, that is, rapid re-melting and solidification of poly-Si with nano-second laser pulse. The most problem which was found in the ELC for crystallization also exists here. The rapid thermal changes during the ELC process leads to an introduction of high thermal stress to the poly-Si films as well as the glass, and hence, the deterioration of device reliability.

The RTA method uses higher temperature but for short duration of time. Typically, the substrate is subjected to temperature approaching 700~1000°C during the RTA, however, the annealing process occurs relatively quickly, in minutes or seconds. An optical heating source such as tungsten-halogen or Xe Arc lamp is often used as the RTA heat source. The problem of the RTA is that the photon radiation from those optical sources has the range of wavelength in which not only the silicon film but also the glass substrate is heated. Therefore, the glass is heated and damaged during the process.

U.S. patent No. 3,424,628 discloses an apparatus and method for treating semi-conductive materials with gases. The treatment of the semi-conductive material takes place on a silicon carbide coated graphite or carbon. No magnetic cores are used in the apparatus.

U.S. patent No. 3,594,227 an apparatus and method for treating with gases at elevated temperatures semi-conductive materials placed on molybdenum disks. No magnetic cores are used in the apparatus.

U.S. patent No. 4180 618 relates to an electronic device and its fabrication, wherein a thin film of silicon is deposited on a substrate made of an aluminosilicate glass.

Based on the prior art, it is of great interest to develop methods for enhancing the kinetics of crystallization and dopant activation for device fabrication on glass, and also to reduce the thermal budget required for those processes.

## SUMMARY OF INVENTION

Accordingly, the objectives of the present invention are to solve the problem described above for once and all.

The present invention provides an apparatus for heat treatment of semiconductor films upon thermally susceptible non-conducting substrates at a minimum thermal budget are required.

The apparatus of the invention comprises:

(a) induction coils installed In dose proximity of semiconductor films on non-conducting substrates, wherein the winding configuration of said induction coils is set in such a way that the current direction of inductor is aligned parallel to the in-plane direction of said semiconductor films,

(b) a susceptor installed below said non-conducting substrates or a box-type furnace installed arround said non-conducting substrates, wherein the susceptor or box-type furnace heats the semiconductor films to the extent that the semiconductor films can be induction-heated,

and it is characterized in that it further comprises magnetic cores made of magnetic metals or ferrite added around the said induction coils for the purpose of strengtherring the magnetic field at lower power and of allowing the concentration of said alternating magnetic flux to close proximity of the semiconductor films, according to claim 1.

The invention also provides a process for heat treatment of for heat treatment of semiconductor films upon thermally susceptible non-conducting substrates, such process using the above apparatus of the invention.

Representative examples of said semiconductor films are silicon films being amorphous silicon films or crystalline silicon films, and representative examples of said thermally susceptible non-conducting substrates are glass and plastic substrates.

According to the methods and apparatus of the present invention, the semiconductor films can be heat-treated without damaging the thermally susceptible substrates: e.g., crystallization of amorphous silicon films at the minimum thermal budget acceptable for the use of glass, enhancing kinetics of dopant activation at the minimum thermal budget acceptable for the use of glass.

Said silicon films are deposited on the glass substrate, in the form of either amorphous state crystallizing into polycrystalline in the case of crystallization heat treatment, or polycrystalline state implanted by dopants (n or p type) in the case of dopant activation heat treatment.

Said susceptor ultimately heats the semiconductor films by heating the non-conducting substrates such as glass and plastic substrates on which the semiconductor films are deposited. The types of susceptors may be selected according to the method of heating of the susceptors as the below.

Firstly, the susceptor is made of metal or graphite with a high conductivity providing the *in-situ* heating capability to the susceptor under the alternating magnetic field through a heating mechanism of eddy currents (i.e., induction heating).

Secondly, the susceptor is made of an electrically non-conductor material preventing the susceptor from being heated under the alternating magnetic field, and the susceptor is designed to be independently heated using an external heat source such as resistance or lamp heater.

The latter type of susceptor provides advantage in the operation of process in that degree of heat treatment effects on the crystallization (or dopant activation) can be independently controlled from the extent of substrate heating in the system operation of varying the strength of magnetic field. In both cases, the temperatures of glass substrates are kept low at the range below 500°C to prevent the damage of glass. The susceptor is in a linear or rotational motion for enhancing the process uniformity.

More preferably, the heat treatment apparatuses comprise further magnetic cores installed inside or around the induction coils. Preferred materials of said magnetic cores are laminated metal core or ferrite core. Advantages of employing magnetic core are three folds. Firstly, it enhances strength of magnetic field substantially with low induction power. Secondly, it makes the distribution of magnetic flux more uniform. Thirdly, it makes the said flux distribution to be concentrated on the region of silicon film, which leads to more efficient heat treatment and to prevention of undesired interference by magnetic flux on the conducting components installed around the susceptor (for instance, chamber wall or external heater block).

Even though any configurations of said magnetic induction coils accomplishing the above goal are applicable in the present invention, preferred examples thereof are described as below.

(1) The magnetic core with a plate shape encapsulates the upper portion of pancake-shaped flat induction coil so that external magnetic flux is generated from the magnetic poles downward to the surface of said silicon film located underneath the said induction coil. This configuration yields magnetic flux distribution in close proximity to the non-conducting substrate without being dissipated away. It is desired that the substrate is subjected to linear motion underneath the coil to impro ____ process uniformity.

(2) The magnetic core with ⎍ -shape (vertically cross-sectional view) which is wound by multi-turn induction coil is located above the semiconductor films allowing exposure of external magnetic flux traveling between two magnetic poles to the semiconductor films. In this configuration, the applied current of induction coil produces the strengthened magnetic field through a function of the magnetic core. The magnetic flux then travels directly from one pole to the other across the air gap. It is desired that the non-conducting substrate under heat treatment is subjected to continuous linear movement underneath the coil to improve the process uniformity.

(3) The magnetic core with

⊏ .

-shape (vertically cross-sectional view) which is wound by multi-turn induction coil is positioned such that said non-conducting substrates are located horizontally at the middle point of air-gap of magnetic poles of the magnetic core. In this configuration, the direction of magnetic flux is collimated in the direction perpendicular to the face of magnetic poles. Since the non-conducting substrate under heat treatment is located at the middle point of two magnetic poles in the parallel direction to the pole face, all the magnetic flux line is perpendicularly aligned to the surface of silicon films coated on the substrate. This alignment can maximize the goal of present invention. Continuous movement of substrate is further desired in terms of better process uniformity and higher throughput.

The described present invention remarkably enhances the kinetics of crystallization of amorphous silicon. Further, the present invention is effective not only for the solid phase crystallization (SPC) but also for the metal-induced crystallization (MIC). The present invention also remarkably enhances the kinetics of dopant activation of ion-implanted polycrystalline silicon.

The possible reason for the present invention to enhance the kinetics of said heat treatment effects may be expressed as below. For simplicity, the semiconductor films are restricted to the silicon films and the thermally susceptible non-conducting substrates are restricted to the glass substrates, respectively.

Induction of alternating magnetic field inside the silicon films leads to generation of eletromagnetic force (emf). Given assumption that the emf in the silicon films is the driving force for the kinetic enhancement, the Faraday's Law (also see B.D. Cullity, "Introduction of Magnetic Materials"(Addison Wesley, Massachusetts, 1972), P. 36) defines the strength of emf as follows:

$$EMF=10^{-8}Nd\Phi/dt \text{ volts}$$

Where N is the number of turns in the coil and $d\Phi/dt$ is the rate of change of magnetic flux in the maxwell/sec unit. Accordingly, the increase of kinetics depends on both the strength of magnetic flux and the alternating frequency.

Even though mechanism for generation of emf to enhance the heat treatment effects is not understood, the couple of reasons can be speculated.

First mechanism is a selective joule heating of silicon films. Amorphous or polycrystalline silicon has high resistivity values at room temperature, for instance, $10^6 \sim 10^{10}$ 'Ω-cm in the case of amorphous silicon. Thus, unless silicon is intentionally heated by external heat source, joule heating of silicon though said emf does not occur. However, when amorphous and polycrystalline Si are heated to elevated temperatures, their resistivities go down rapidly to the low values, for instance, $10 \sim 0.01$ 'Ω-cm at 500°C Those resistivity values are similar to those of graphite ($1 \sim 0.001$ 'Ω-cm) used as an example of the susceptor in the present invention. In spite of local heating of amorphous silicon under alternating magnetic flux, the glass substrate having high resistivity values ($\sim 10^{16}$ 'Ω-cm) is not heated by said alternating magnetic flux. Thus, the glass remains to be at low temperatures pre-set by the external heating operation.

Second mechanism is that said emf activates the movement of silicon atoms through a field effect functioning on the charged defects. It is known that point defects such as vacancies and interstitials are electrically charged (negatively or positively) in the silicon atomic structure. Motion of those charged defects are significantly enhanced by the presence of electric field, which has been commonly reported in the academic publications (e.g., "Field-Enhanced Diffusion" in silicon, see S.M. Sze "VLSI Technology" (2nd ed. McGraw Hill, 1988), P. 287).

It is to be understood that both the foregoing general description and the following detailed description are exemplary and explanatory, and are intended to provide further explanation of the invention as claimed.

BRIEF DESCRIPTION OF DRAWINGS

The accompanying drawings, which are included to provide a further understanding of the invention and are incorporated in and constitute a part of this specification, illustrate embodiments of the invention that together with the description serve to explain the principles of the invention.

FIG. 1 is a schematic view of low temperature heat treatment apparatus using solenoid induction coils.

FIG. 2 is a schematic view of low temperature heat treatment apparatus using a spiral induction coil.

FIG. 3 is a schematic view of a preferred embodiment of low temperature heat treatment apparatus according to the present invention having an addition of magnetic core.

FIG. 4 is a schematic view of a preferred embodiment of low temperature heat treatment apparatus according to the present invention using the magnetic core of ⊓⊐ -shape.

FIG. 5 is a schematic view of a preferred embodiment of low temperature heat treatment apparatus according to the present invention using the magnetic core of ⊏⊐ -shape.

FIG. 6 is a schematic view of amorphous silicon films on glass substrate for the SPC heat treatment.

FIG. 7 is a graph showing the changes of x-ray (111) peaks as a function of heat treatment time under the present invention and a prior art

FIGS 8a and 8b are the micrographs of scanning electron microscopy showing the grain structures for films heat-treated at the time stage of the completion of crystallization in FIG. 7.

FIG 9 is a graph showing the influence of coil current (i.e., strength of magnetic field) on the kinetics of crystallization under the present invention.

FIG. 10 is a schematic view of amorphous silicon films on glass substrate for MIC heat treatment, where Ni layer is deposited on the amorphous silicon films

FIG. 11 is a schematic view of amorphous silicon films on glass substrate for MILC heat treatment, where Ni layer is selectively deposited on the amorphous silicon films and nickel reacts with the silicon underneath the nickel to form a polycrystalline silicon containing a nickel-silicide.

FIGS 12a~12c are optical micrographs showing the change of pattern structure of a T-shape photo-mask after the lateral crystallization according to the present invention and a prior art.

FIG 13 is a graph showing the change of lateral growth length as a function of coil current.

FIGS 14a and 14b are graphs showing the changes of measured sheet resistance as a function of period for heat treatment.

DETAILED DESCRIPTION OF PREFERRED EMBODIMENT

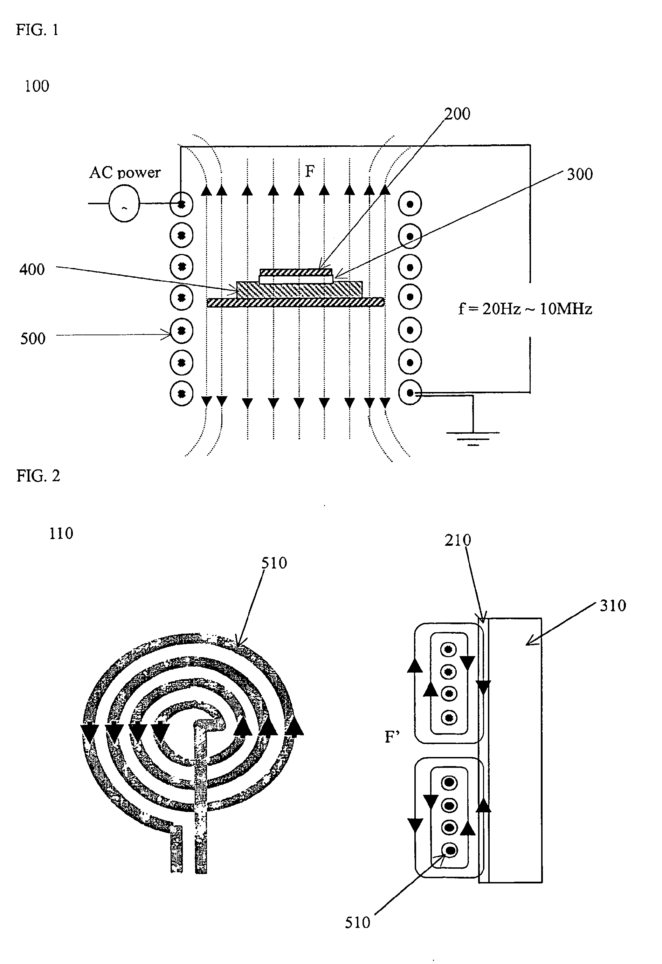

Referring to FIG 1, an apparatus allowing low temperature heat treatments of a silicon film on a glass substrate. This apparatus can be used for heat treatments of both crystallization of amorphous silicon and dopant activation of ion-implanted silicon.

Apparatus 100 consists of a graphite susceptor 400 heating the glass substrate 300 coated with the silicon film 200 and a solenoid induction coil 500 generating magnetic field (F). Introduction of alternating current in the water-cooled induction coil leads to a generation of alternating magnetic field (F). The alternating magnetic flux is utilized for two purposes. First is to heat the graphite susceptor 400 through a function of joule heating effects (i.e., heating mechanism of a conventionally used induction furnace). Second is to enhance the kinetics of heat treatments of silicon films 200 through an inducted emf inside the silicon films 200. In order to see the enhancement effects, the glass 300 should be mounted in the horizontal direction so that the magnetic flux is aligned with perpendicular direction to the surface of silicon film 200. The extent of the kinetic enhancement is increased by increasing alternating frequency and/or magnetic field strength in accordance with Faraday's Law as described previously. Preferred frequency range is from 20 Hz to 10 MHz.

In order to increase the said magnetic field strength, the power (or current) of induction coil 500 should be increased. Here, said action leads to an increase of heating temperature of graphite susceptor 400. Thus, species of materials, thickness, and shape of used susceptor 400 should be adequately adjusted to keep the susceptor temperature at low range (200~500 °C).

Referring to FIG.2, an apparatus in a different coil design from that in the apparatus 100 of FIG.1. The apparatus 110 consists of water-cooled induction coil 510 having a pancake shape with spiral winding turns. Spiral coil configuration is adequate for heat treatment of sheet objects such as glass. Spiral induction coil 510 generates magnetic flux (F') onto the glass substrate 310 coated with silicon film 210. While the present embodiment yields a fairly uniform process characteristic, further uniformity is achieved by linear or rotating motion of glass substrate 310.

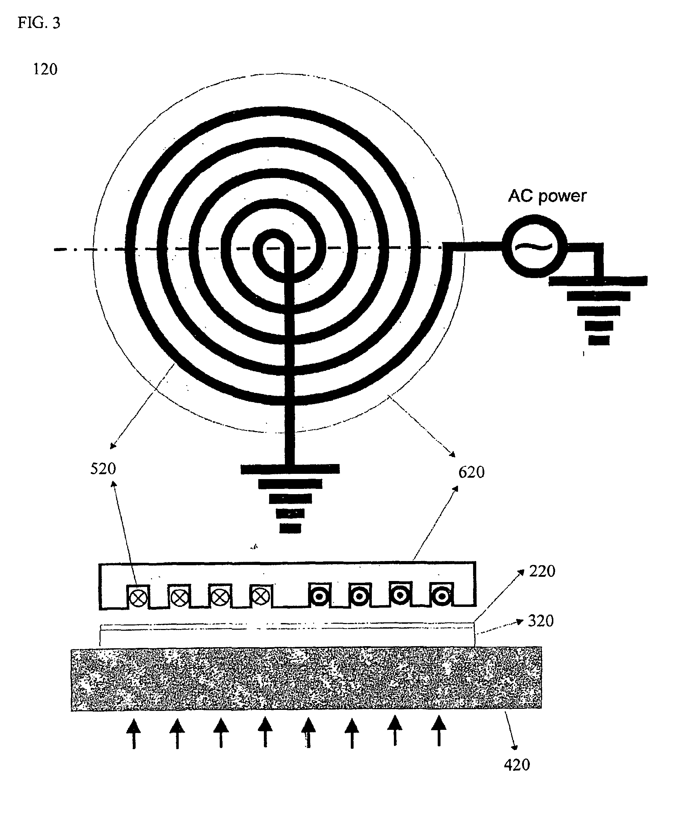

Turning to FIG.3, the present embodiment relates to an apparatus having an addition of magnetic core in order to achieve a further advancement of the present invention. The apparatus 120 has a coil configuration 520 identical to that in the apparatus 110 of FIG.2. The upper half portion of induction coil 520 is encapsulated by magnetic core 620 made of laminated magnetic metals (e.g., Iron-Silicon alloy or Ni alloy) or ferrite (e.g., Mn-Zn Ferrite). Both the induction coil 520 and the magnetic core 620 are water-cooled properly to prevent an excessive heating thereof during the operation, if necessary. As seen in the figure, the low portion of the coil 520 is open and forms an external magnetic flux.

The distribution shape of magnetic flux is similar to that in FIG.2. however, the field strength of present embodiment is substantially higher than that of FIG. 2 due to an amplification action by magnetic core 620, in accordance with the relationship;

$$B=H+4\pi Ms,$$

where H is the applied field by coil and $4\pi Ms$ is the magnetization of magnetic core 620, and B is the total induction of magnetic flux in CGS unit (refer to B.D. Cullity, "Introduction of Magnetic Materials" (Addison Wesley, Massachusetts, 1972), P. 13). The maximum field strength (B) in the induction with magnetic core 620 is limited to the value of magnetization saturation ($4\pi Ms$) of magnetic core, for instance, 10~20 kilogauss and 2~7 kilogauss for metal alloys and ferrites, respectively. However, those large B values can be hardly achieved in the case of air-core inductor as in FIGS. 1 and 2. Thus, use of magnetic induction coil design in the present embodiment substantially increases the degree of heat treatment effects of silicon films 220 at a low induction power.

As shown in FIG. 3, the susceptor 420 is located underneath the induction coil 520. The susceptor 420 is made of materials having non-magnetic, non-conductive, and high thermal conductive properties such as AlN and BN. The susceptor 420 is heated to 200~500 °C by external heat sources such as resistive heater and lamp heater (not shown in the figure). The use of external heating yields the allowance of independent control of glass substrate temperature and magnetic flux density on silicon films 220, which is not the case in FIGS 1 and 2.

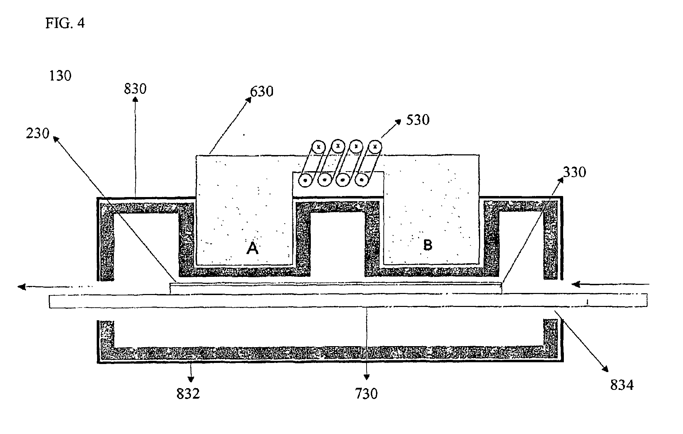

Referring to FIG. 4, the apparatus 130 comprises three important components; ⊓⊓ -shape (vertically cross-sectional view) magnetic core 630 wound by multi-turn of induction coil 530, box-shape furnace 830, and transport system 730 for linear motion of glass substrate 330. The glass substrate 330 with Si film 230 is laid horizontally on the conveyer 730 linearly moving through the open aperture 834 of the furnace wall 832. Alternating coil current generates alternating magnetic flux circulating magnetic core 630, and traveling back and forth from one pole (A) to another (B). This distribution of flux produces the vertical flux line to the surface of silicon film 230 at the regions underneath the poles (A and B) leading to an enhancement of kinetics at those areas in the silicon films 230. Since the region of heat treatment is localized within the pole region (underneath of A and B), the linear motion of glass substrate 230 is needed for achieving the uniformity. Magnetic core 630, especially, the magnetic pole regions (A and B) should be insulated thermally from the hot zone of the furnace. Thus, those magnetic cores 630 should be water-cooled by a proper cooling component and be encapsulated by thermal insulator 832.

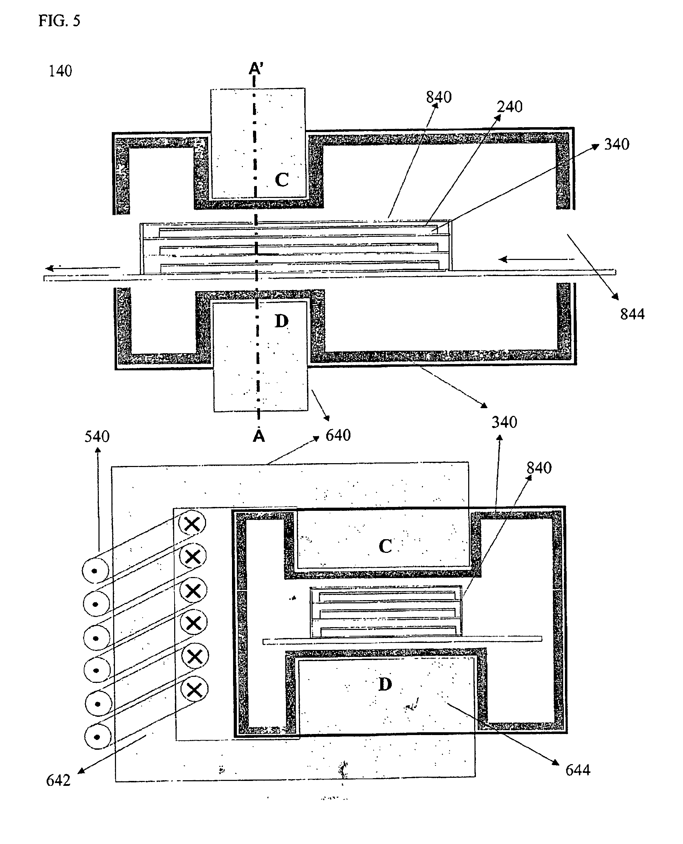

Turning to FIG 5, described is an another type of apparatus having a magnetic core in order to achieve a further advancement of the present invention. In particular, the apparatus of the present embodiment allows the heat treatment of multiple number of glasses by a single process running (i.e., batch process). The apparatus 140 comprises three main components; ⊏ -shaped magnetic core in the view of vertical cross-section, box-type furnace, and transport system of glass substrate. The vertical column 642 of left side of magnetic core 620 is located outside the furnace 340 and is wounded by induction coil 540, and the open pole column of right side 644 is embedded inside the body of furnace. The glass substrate 340 with Si film 240 is laid horizontally on the conveyer 730 linearly moving through the open aperture 844 of the furnace wall 340. Alternating coil current generates alternating magnetic flux circulating magnetic core 640, and traveling back and forth from one pole (C) to another (D). This distribution of flux produces the collimated flux line in the direction perpendicular to the surface of silicon film 240 at the pole regions (C and D). This alignment maximizes the heat treatment effect on silicon films 240, compared to the apparatus disclosed in the previous figures (first through fourth embodiment). Further advantage of present embodiment is an allowance of batch process, as will be described next. As shown in the FIG. 5, a multiple number of glasses 340 are inserted in a loading cassette 840. Then, the cassette on the conveyor passes through between the pole gap (between C and D), being subjected to heat treatment. The material used for the cassette frame 840 should be non-magnetic to prevent the interference of magnetic field as well as to keep the magnetic transparency. Preferred material for cassette frame 840 is quartz. Since the magnetic flux is vertically aligned to all the glasses 340 in the cassette 840, a uniform amount of heat treatment among the individual glasses 340 can be achieved.

Heat Treatment For SPC

The present embodiment relates to heat treatment for the solid phase crystallization (SPC) of amorphous silicon films on glass substrate utilizing the apparatus 100 as disclosed in FIG. 1.

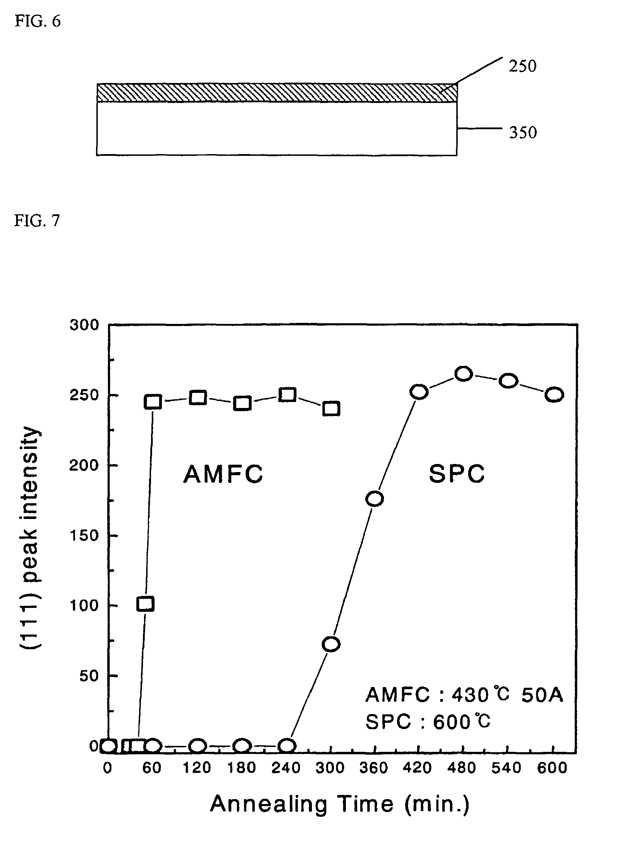

As shown in FIG. 6, an amorphous silicon film 250 was deposited on glass substrate (Corning 1737: 350) to a thickness of 1000 Å. Then, the sample was heated using the apparatus 100. The induction coil 500 had a diameter of 15 cm and a turn number of 14. Applied alternating frequency was 14 KHz. The applied coil current was 45 ampere. These set-up conditions give the strength of induction field of approximately 50 Oersted (Oe) to the amorphous silicon films 200 on glass substrate 300. The substrate temperature was varied by change of thickness of graphite susceptor 300, taking account the reference depth of eddy current according to the principle of induction heating.

First, in order to investigate the kinetics of SPC, x-ray diffraction analysis was carried out. For comparison, the sample prepared by said method was heat treated in a conventional tube furnace with a resistance heater. FIG. 7 shows the changes of x-ray (111) peaks as a function of heat treatment time. The evolution of (111) peaks indicates the crystallization of amorphous silicon, and the saturation of intensity indicates the completion of crystallization.

As can be seen in FIG.7, in the case of conventional heat treatment (SPC), crystallization started to occur at 4 hours and completed at 7 hours even at the elevated temperature of 600°C. In contrast, in the case of heat treatment according to the present invention (AMFC), crystallization was completed within an hour in spite of low temperature of 430°C.

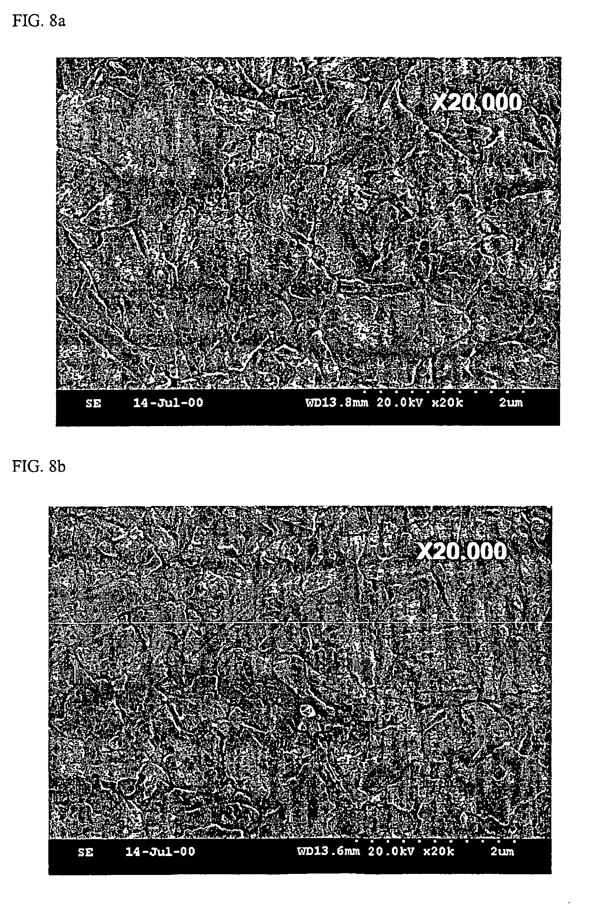

In the experiment described above, grain structures of polycrstalline silicon films were investigated by electron microscopy. FIG. 8(a) and (b) are the micrographs of scanning electron microscopy showing the grain structures for films heat-treated at the time stage of the completion of crystallization in FIG. 7, in specific, 1 hr for the present invention method (FIG. 8(a)) and 7 hrs for the conventional method (FIG. 8(b)). Observation of similar grain structure with a large grain size of 2~3 um between two methods reveals that a high crystalline quality of polycrystalline silicon is obtained by the present invention even at low temperature of heat treatment.

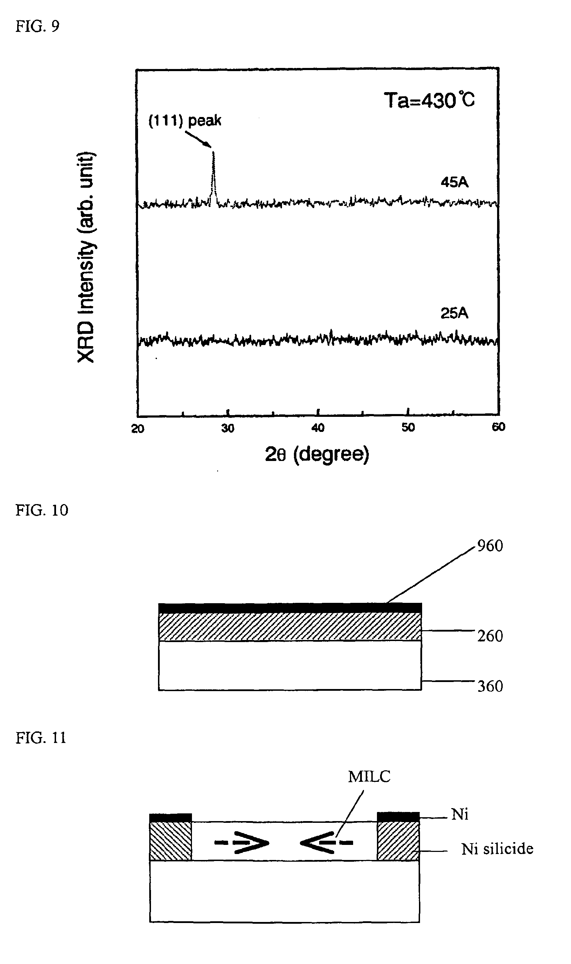

In the experiment described above, the influence of coil current (i.e., strength of magnetic field) on the kinetics of crystallization was investigated. FIG. 9 compares the (111) x-ray peaks for coil current of 25 ampere and 45 ampere at 1 hr of heat treatment time. Whereas the crystallization was completed at 1 hr for coil current of 45 ampere as described above, it was not occurred for coil current of 25 ampere. This result provides the direct evidence that the strength of magnetic field is important for enhancing the kinetics of crystallization. Since strength of magnetic field at 25 ampere was measured to be approximately 28 Oe, it is considered that the crystallization is enhanced above the value at the specific conditions of present experiments.

Heat Treatment for MIC

The present embodiment relates to heat treatment for the metal-induced crystallization (MIC) of amorphous silicon films on glass substrate utilizing the apparatus 100 as disclosed in FIG. 1.

As shown in FIG. 10, an amorphous silicon film 260 was deposited onto the glass substrate 360 to a thickness of 1000 angstrom, and Ni 960 was subsequently deposited to a thickness of 30 angstrom. The experimental conditions in diameter, number of turn, and frequency of induction coil were identical to that in the above.

First, heat treatments were performed on the samples described above for 1 hour at various temperatures. Here, coil current was set to 45 ampere. Next, the occurrence of crystallization in those samples was checked by the x-ray diffraction analysis and the electron microscopy. The result is presented in Table 1.

TABLE 1

| embodiments | Coil current | Heat treatment Temperature/time | Occurrence of crystallization |
|---|---|---|---|
| 1 | 45 ampere | 250°C / 1 hr | X |
| 2 | 45 ampere | 300°C / 1 hr | O |
| 3 | 45 ampere | 350°C / 1 hr | O |
| 4 | 45 ampere | 400°C / 1 hr | O |
| 5 | 45 ampere | 450°C / 1 hr | O |

Heat Treatment for MILC

The present embodiment relates to heat treatment for the metal-induced lateral crystallization (MILC) of amorphous silicon films on glass substrate utilizing the apparatus 100 as disclosed in FIG. 1.

FIG. 11 shows the schematic description of the action of MILC. First, the amorphous silicon film was deposited onto the glass substrate to a thickness of 1000 angstrom. Next, Ni (nikel) film was selectively deposited onto the amorphous silicon to a thickness of 30 angstrom. The selective deposition of Ni was carried out using optical lithographic and etching method.

As illustrated in FIG. 11, at the early stage of the heat treatment, nickel reacts with the silicon underneath the nickel to form a polycrystalline silicon containing a nickel-silicide. As heat treatment further proceeds, the crystalline silicon region expands laterally into the amorphous silicon region. Thus, this reaction is referred as to metal-induced-lateral crystallization. Prior arts are disclosed on the methods relating to the MTLC.

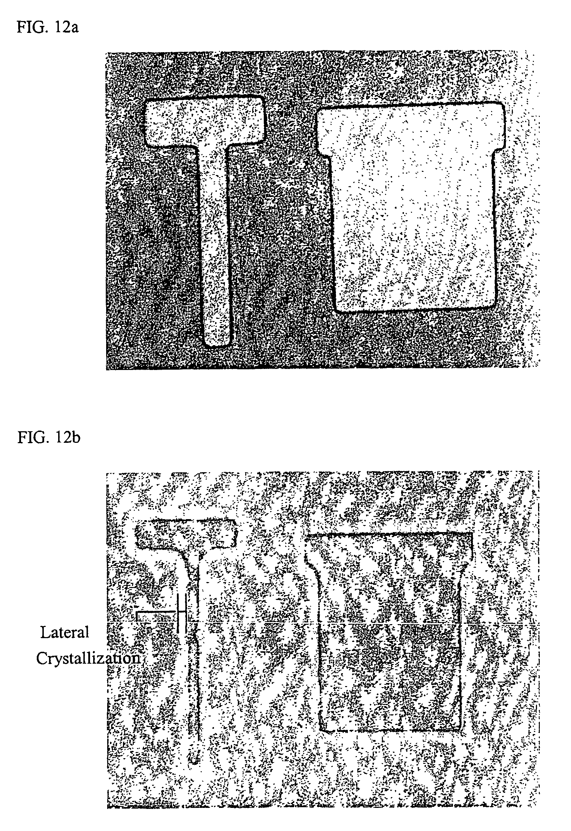

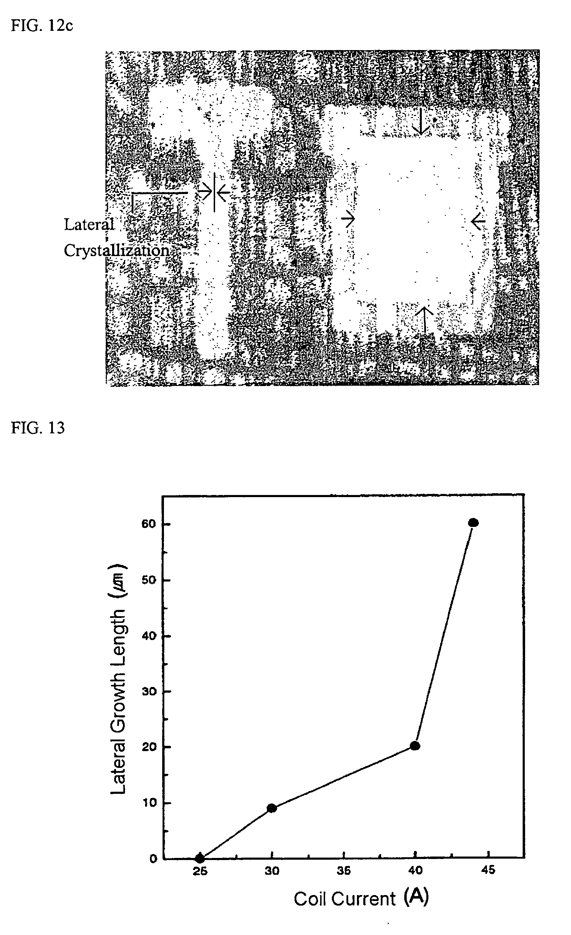

FIG. 12a is the optical micrograph showing the pattern structure after patterning with a T-shape photo-mask. Here, the region inside the T pattern is the region wherein Ni does not exist. Accordingly, the region outside the T pattern is covered by Ni film. FIG. 12b is the optical micrograph for the case of conventional heat treatment at 500°C for 7 hours using a tube furnace. FIG. 12c is the case of heat treatment of the present invention at 430°C for 1 hr. For the invented heat treatment, diameter, number of turn, and frequency of induction coil were identical to that in the above. Here, 40 ampere of coil current was applied.

As shown in the figures, the conventional heat treatment (FIG. 12b) leaded to a short lateral crystallization growth (approximately, 10 $\mu$m in length) even at high temperature (500°C) and for long process period (7 hours). In contrast, when the invented heat treatment method was applied, substantially longer lateral grew (approximately, 25 $\mu$m in length) even at low temperature (430°C) and for short process period (1 hour).

FIG. 13 shows the change of lateral growth length as a function of coil current, According to the graph, the lateral growth is rapidly enhanced above critical current value of 25 ampere. As described in the above, the magnetic strength at 25 ampere of induction current corresponds to 28 Oe.

Heat Treatment for the Dopant Activation

The present embodiment relates to heat treatment for the dopant activation of polycrystalline silicon films on glass substrate utilizing the apparatus 100 as disclosed in FIG. 1.

A 500 angstrom-thick amorphous silicon film deposited on the glass was crystallized into a polycrystalline form by heat treatment at 430°C for 1 hour using the apparatus 100. Used diameter, number of turn, and frequency were identical to those in the above. Said polycrystalline silicon films was then ion-implanted with phosphorus (n-type dopant) ion by a plasma doping system using $PH_3$ gas. During the plasma ion doping, process pressure of $PH_3$ gas was 3 mTorr and acceleration voltage is 20 KV. The implanted samples were heat-treated for dopant activation in the apparatus described above and in the conventional tube furnace, respectively.

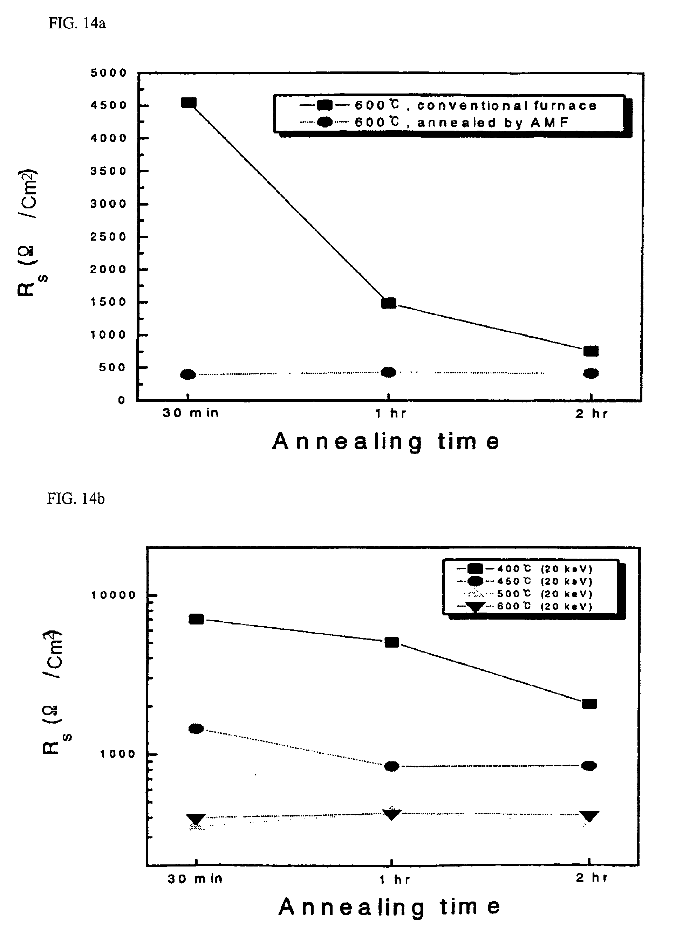

The degree of activation is determined by measurement of sheet resistance of silicon film. FIG. 14a shows the change of measured sheet resistance as a function of period for 600°C heat treatment. At 600°C, the sheet resistance is decreased to a value of 700 ohm/cm$^2$ after 2 hours when the conventional furnace is used. In contrast, the sheet resistance already shows a low value of 400 ohm/cm$^2$ at 30 minutes when the apparatus of the present invention is used (AMF).

FIG. 14b shows the changes of sheet resistance as a function of heat treatment time for various temperatures, in the case of the present invention. According to the figure, the invented method yields a low sheet resistance below 1000 ohm/ cm$^2$ at 450°C for 30 minutes.

ADDITIONAL APPLICATIONS OF PRESENT INVENTION

It should be understood that application of the apparatus claimed in the present invention is not limited to the specific objectives of the present invention (i.e., crystallization of amorphous silicon and dopant activation). As more specific examples, the apparatus and the methods of the present invention can be used in the low-temperature heat treatment of indium-tin-oxides (ITO) or metal films on a glass (or plastic) in the display, microelectronics, and solar cell industries. It is also thought that the same means and methods can be used in a number of other processes wherein heat treatments of conductor or semi-conductor films upon thermally susceptible non-conducting substrates (typically glass or plastics) at a minimum thermal budget are required.

The invention being thus described, it will be obvious that the same way may be varied in many ways. Such variations are not to be regarded as a departure from the scope of the invention, and all such modifications as would be obvious to one skilled in the art were intended to be included within the scope of the following claims.

**Claims**

**1.**  An apparatus (120,130,140) for heat treatment of semiconductor films (220,230,240) upon thermally susceptible non-conducting substrates (320,330,340) comprising:

(a) induction coils (520,530,540) installed in close proximity of semiconductor films (220,230,240) on non-conducting substrates (320,330,340), wherein the winding configuration of said induction coils (520,530,540) is set in such a way that the current direction of inductor is aligned parallel to the in-plane direction of said semiconductor films (220,230,240),
(b) a susceptor (400,420) installed below said non-conducting substrates or a box-type furnace (830) installed around said non-conducting substrates, wherein the susceptor (400,420) or box-type furnace (830) heats the semiconductor films (220,230,240) to the extent that the semiconductor films (220,230,240) can be induction-heated,

**characterized in that** it further comprises magnetic cores (620,630,640) made of magnetic metals or ferrite added around the said induction coils (520,530,540) for the purpose of strengthening the magnetic field at lower power and of allowing the concentration of said alternating magnetic flux to close proximity of the semiconductor films (220,230,240).

**2.**  The apparatus of Claim 1, wherein said susceptor (400) is made of metal or graphite with a high conductivity providing the in-situ heating capability to the susceptor (400,420) under the alternating magnetic field through a heating mechanism of eddy currents.

**3.**  The apparatus of Claim 1, wherein said susceptor (420) is made of an electrically non-conductor material preventing the susceptor from being heated under the alternating magnetic field, and the susceptor is designed to be independently heated using an external heat source such as resistance or lamp heater.

4. The apparatus of Claim 1, wherein a magnetic core (620) with a plate shape encapsulates the upper portion of pancake-shaped flat induction coils (520) so that external magnetic flux is generated from the magnetic poles downward to the surface of said semiconductor film (220) located underneath the said induction coils (520) and wherein said semiconductor film is a silicon film.

5. The apparatus of Claim 1, wherein a magnetic core (630) with n-shape which is wound by multi-turn induction coil is located above the semiconductor films (230) allowing exposure of external magnetic flux traveling between two magnetic poles to the semiconductor films (230).

6. The apparatus of Claim 1, wherein a magnetic core (640) with C-shape which is wound by multi-turn induction coil is positioned such that said non-conducting substrates (340) are located horizontally at the middle point of air-gap of magnetic poles of the magnetic core (640).

7. The apparatus of Claim 6, wherein multiple number of non-conducting substrates (340) are inserted into a load cassette (840) and is exposed to said magnetic flux simultaneously during a single process run for increasing the throughput of heat treatment.

8. The apparatus of Claim 1 wherein said susceptor is in a linear or rotational motion for enhancing the process uniformity.

9. A method for heat treatment of semiconductor films upon thermally susceptible non-conducting substrates, said method using the apparatus of any one of claims 1- 8.

10. The method of claim 9, wherein said semiconductor films (220,230,240) are silicon films being amorphous silicon films or crystalline silicon films, said thermally susceptible non-conducting substrates are glass and plastic substrates (320,330,340).

11. The method of claim 10, wherein said silicon films (220,230,240) are amorphous films deposited onto the glass for the purpose of crystallization, or polycrystalline films ion-implanted with a n-type or p-type dopant for the purpose of electrical activation.

12. The method of claim 11, wherein said crystallization of amorphous silicons is solid phase crystallization, metal-induced crystallization, and/or metal-induced lateral crystallization.

13. The method of claim 9, wherein an alternating current of said induction coils (520,530,540) having an the alternating frequency of from 10 Hz to 10 MHz is used.

**Patentansprüche**

1. Vorrichtung (120,130,140) zur Wärmebehandlung von Halbleiterfilmen (220,230,240) auf thermisch empfindlichen nichtleitenden Substraten (320,330,340) mit:

(a) Induktionsspulen (520,530,540), die in nächster Nähe von Halbleiterfilmen (220,230,240) auf nichtleitenden Substraten (320,330,340) installiert sind, wobei die Windungskonfiguration der Induktionsspulen (520,530,540) auf so eine Art gegeben ist, dass die Stromrichtung des Induktors parallel zur Richtung in der Ebene der Halbleiterfilme (220,230,240) ausgerichtet ist,
(b) einem Suszeptor (400,420), der unter den nichtleitenden Substraten installiert ist, oder einem kastenartigen Ofen (830), der um die nichtleitenden Substrate herum installiert ist, wobei der Suszeptor (400,420) oder der kastenartige Ofen (830) die Halbleiterfilme (220,230,240) so weit aufheizt, dass die Halbleiterfilme (220,230,240) induktionsbeheizt werden können,

**dadurch gekennzeichnet, dass** sie ferner magnetische Kerne (620,630,640) aufweist, die aus magnetischen Metallen oder Ferriten hergestellt sind und die um die Induktionsspulen (520,530,540) herum hinzugefügt werden, um das magnetische Feld bei geringer Leistung zu verstärken und um die Konzentration des wechselnden Induktionsflusses in der Nähe der Halbleiterfilme (220,230,240) zu gestatten.

**2.** Vorrichtung nach Anspruch 1, wobei der Suszeptor (400) aus Metall oder Graphit mit einer hohen Leitfähigkeit hergestellt ist, wobei dem Suszeptor (400,420) die in-situ Heizfähigkeit unter dem alternierenden magnetischen Feld durch einen Heizmechanismus von Wirbelströmen bereit gestellt ist.

**3.** Vorrichtung nach Anspruch 1, wobei der Suszeptor (420) aus einem elektrischen Nichtleiter-Material hergestellt Ist, das verhindert, dass der Suszeptor unter dem alternierenden magnetischen Feld aufgeheizt wird, und wobei der Suszeptor dafür ausgebildet ist, unabhängig unter Verwendung einer externen Wärmequelle wie einer Widerstandsheizung oder einer Lampenheizung beheizt zu werden.

**4.** Vorrichtung nach Anspruch 1, wobei ein magnetischer Kern (620) mit einer Plattenform den oberen Abschnitt von pfannkuchenartig geformten, flachen Induktionsspulen (520) so umschließt, dass ein äußerer Induktionsfluss von den Magnetpolen nach unten auf die Oberfläche des Halbleiterfilms (220) erzeugt wird, der unterhalb der Induktionsspule (520) angeordnet ist, und wobei der Halbleiterfilm ein Silikonfilm ist.

**5.** Vorrichtung nach Anspruch 1, wobei ein magnetischer Kern (630) mit n-Form, der durch eine Multiturn-Induktionsspule gewunden ist, über dem Halbleiterfilm (230) angeordnet ist, was es ermöglicht, dem äußeren Induktionsfluss ausgesetzt zu sein, der zwischen zwei magnetischen Polen zu den Halbleiterfilmen (230) wandert.

**6.** Vorrichtung nach Anspruch 1, wobei ein magnetischer Kern (640) mit einer C-Form, der durch eine Multiturn-Induktionsspule gewunden ist, so positioniert ist, dass die nichtleitenden Substrate (340) horizontal am Mittelpunkt eines Luftspalts von magnetischen Polen des magnetischen Kerns (640) angeordnet ist.

**7.** Vorrichtung nach Anspruch 5, wobei eine Mehrzahl von nichtleitenden Substraten (340) in einer Ladekassette (840) eingesetzt wird und dem Induktionsfluss gleichzeitig während eines einzigen Verfahrensablaufs ausgesetzt wird, um den Durchsatz der Wärmebehandlung zu steigern.

**8.** Vorrichtung nach Anspruch 1, wobei der Suszeptor sich in einer linearen Bewegung oder in einer Rotationsbewegung befindet, um die Prozesshomogenität zu verbessern.

**9.** Verfahren zur Wärmebehandlung von Halbleiterfilmen auf thermisch empfindlichen nichtleitenden Substraten, wobei das Verfahren die Vorrichtung nach einem der Ansprüche 1 bis 8 verwendet.

**10.** Verfahren nach Anspruch 9, wobei die Halbleiterfilme (220,230,240) Silikonfilme sind, die amorphe Silikonfilme oder kristalline Silikonfilme sind, wobei die thermisch empfindlichen nichtleitenden Substrate Glas- oder Kunststoffsubstrate (320,330,340) sind.

**11.** Verfahren nach Anspruch 10, wobei die Silikonfilme (220,230,240) amorphe Filme sind, die auf Glas für die Zwecke einer Kristallisation abgeschieden sind oder polykristalline Filme sind, die mit einer Dotierung vom n-Typ oder p-Typ ionenimplantiert sind, für die Zwecke einer elektrischen Aktivierung.

**12.** Verfahren nach Anspruch 11, wobei die Kristallisation von amorphen Silikonen eine Festphasen-Kristallisation, metallinduzierte Kristallisation und/oder metallinduzierte Lateralkristallisation ist.

**13.** Verfahren nach Anspruch 9, wobei ein Wechselstrom der Induktionsspulen (520,530,540) verwendet wird, der eine alternierende Frequenz von 10 Hz bis zu 10 MHz hat.

**Revendications**

**1.** Un appareil (120,130,140) pour le traitement thermique de films semi-conducteurs (220,230,240) sur des substrats non conducteurs à susceptibilité thermique (320,330,340), comprenant :

(a) des bobines d'induction (520,530,540) installées à proximité immédiate de films semi-conducteurs (220,230,240) sur des substrats non conducteurs (320,330,340), dans lesquelles la configuration d'enroulement desdites bobines d'induction (520,530,540) est prévue de telle sorte que la direction du courant de l'inducteur est alignée parallèlement à la direction dans le plan desdits films semi-conducteurs (220,230,240),
(b) un suscepteur (400,420) installé sous lesdits substrats non conducteurs, ou un four du type boîte (830) installé autour desdits substrats non conducteurs, dans lequel le suscepteur (400,420) ou le four du type boîte (830) chauffe les films semi-conducteurs (220,230,240) jusqu'à ce que les films semi-conducteurs (220,230,240) puissent être chauffés par induction,

**caractérisé en ce qu'**il comprend en outre des noyaux magnétiques (620,630,640) constitués de métaux magnétiques ou de ferrite ajoutés autour desdites bobines d'induction (520,530,540) dans le but de renforcer le champ magnétique lorsque la puissance est faible et de permettre la concentration du flux magnétique alternatif à proximité immédiate des films semi-conducteurs (220,230,240).

2. L'appareil selon la revendication 1, dans lequel ledit suscepteur (400) est constitué d'un métal ou de graphite ayant une conductivité élevée et fournissant la capacité de chauffage in-situ au suscepteur (400,420) sous le champ magnétique alternatif par un mécanisme de chauffage à courants eddy.

3. L'appareil selon la revendication 1, dans lequel ledit suscepteur (420) est constitué d'un matériau électriquement non conducteur empêchant le suscepteur d'être chauffé sous le champ magnétique alternatif, et le suscepteur est conçu pour être chauffé indépendamment en utilisant une source de chaleur externe telle qu'une résistance ou une lampe chauffante.

4. L'appareil selon la revendication 1, dans lequel un noyau magnétique (620) de forme plate encapsule la partie supérieure des bobines d'induction plates en forme de crêpe (520) de sorte que le flux magnétique externe soit généré depuis les pôles magnétiques vers le bas vers la surface dudit film semi-conducteur (220) situé sous lesdits bobines d'induction (520) et dans lequel ledit film semi-conducteur est un film de silicium.

5. L'appareil selon la revendication 1, dans lequel un noyau magnétique (630) en forme de n enroulé en bobine d'induction à boucles multiples est situé au-dessus des films semi-conducteurs (230) de façon à permettre une exposition des films semi-conducteurs (230) au flux magnétique externe circulant entre les deux pôles magnétiques.

6. L'appareil selon la revendication 1, dans lequel un noyau magnétique (640) en forme de C enroulé en bobine d'induction à boucles multiples est positionné de telle sorte que lesdits substrats non conducteurs (340) soient situés horizontalement au point central de l'entrefer des pôles magnétiques du noyau magnétique (640).

7. L'appareil selon la revendication 6, dans lequel de multiples substrats non conducteurs (340) sont insérés dans une cassette de chargement (840) et sont exposés audit flux magnétique simultanément durant un processus unique pour augmenter le rendement du traitement thermique.

8. L'appareil selon la revendication 1, dans lequel ledit suscepteur est en mouvement linéaire ou rotationnel pour améliorer l'uniformité du processus.

9. Un procédé de traitement thermique de films semi-conducteurs sur des substrats non conducteurs à susceptibilité thermique, ce procédé utilisant l'appareil selon l'une quelconque des revendications 1 à 8.

10. Le procédé selon la revendication 9, dans lequel lesdits films semi-conducteurs (220,230,240) sont des films de silicium qui sont des films de silicium amorphe ou des films de silicium cristallin, lesdits substrats non conducteurs à susceptibilité thermique étant des substrats de verre et de plastique (320,330,340).

11. Le procédé selon la revendication 10, dans lequel lesdits films de silicium (220,230,240) sont des films amorphes déposés sur le verre en vue d'une cristallisation, ou des films poly-cristallins à implantation ionique avec un dopant du type n ou p en vue d'une activation électrique.

12. Le procédé selon la revendication 11, dans lequel ladite cristallisation du silicium amorphe est une cristallisation en phase solide, une cristallisation induite par un métal et/ou une cristallisation latérale induite par un métal.

13. Le procédé selon la revendication 9, dans lequel on utilise dans lesdites bobines d'induction (520,530,540) un courant alternatif ayant une fréquence d'alternance de 10 Hz à 10 MHz.

FIG. 1

100

AC power

F

200

300

400

500

f = 20Hz ~ 10MHz

FIG. 2

110

510

210

310

F'

510

FIG. 3

120

AC power

520

620

220

320

420

FIG. 4

FIG. 5

FIG. 6

FIG. 7

FIG. 8a

FIG. 8b

FIG. 9

FIG. 10

FIG. 11

FIG. 12a

FIG. 12b

Lateral
Crystallization

FIG. 12c

FIG. 13

FIG. 14a

FIG. 14b

**EP 1 271 620 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 3424628 A
- US 3594227 A

- US 4180618 A

**Non-patent literature cited in the description**

- **B.D. CULLITY.** Introduction of Magnetic Materials. Addison Wesley, 1972, 36
- **S.M. SZE.** VLSI Technology. McGraw Hill, 1988, 287

- **B.D. CULLITY.** Introduction of Magnetic Materials. Addison Wesley, 1972, 13